# EUROPÄISCHE PATENTSCHRIFT

(11) **EP 2 852 988 B1**
(45) Veröffentlichungstag und Bekanntmachung des Hinweises auf die Patenterteilung: **29.06.2016**
(21) Anmeldenummer: 13714281.6
(22) Anmeldetag: 03.04.2013
(51) Int. Cl.: H01L 41/04, H01L 41/113, H01L 41/193, H02N 2/18

(54) **GENERATOREN AUS ELEKTROAKTIVEN POLYMEREN (EAP) IN DIFFERENZANORDNUNG**
GENERATORS MADE OF ELECTROACTIVE POLYMERS (EAP) IN DIFFERENTIAL ASSEMBLY
GÉNÉRATEURS À BASE DE POLYMÈRES ÉLECTROACTIFS (EAP) DANS UNE CONFIGURATION DIFFÉRENTIELLE

(30) Priorität: 22.05.2012 DE 102012208557
(43) Veröffentlichungstag der Anmeldung: 01.04.2015
(73) Patentinhaber: Robert Bosch GmbH, 70442 Stuttgart (DE)
(72) Erfinder: KAMIZURU, Yukio, 52064 Aachen (DE); DENES, Istvan, 71336 Waiblinge/Hohenacker (DE); KUHNEN, Klaus, 66128 Saarbrücken (DE)
(86) Internationale Anmeldenummer: PCT/EP2013/057038
(87) Internationale Veröffentlichungsnummer: WO 2013/174561

(56) Entgegenhaltungen:
- WO-A1-2011/105913
- WO-A2-01/65615
- JP-A- 2012 119 595
- JP-B- 4 796 657
- US-A1- 2011 285 131
- US-A1- 2011 298 215

## Beschreibung

### Stand der Technik

Die vorliegende Erfindung betrifft Generatoren aus elektroaktiven Polymeren (EAP), wie sie beispielsweise in Generatoren zur Wandlung von Wellenenergie in elektrische Energie Verwendung finden können. Die vorliegende Erfindung betrifft insbesondere eine konkrete Anordnung zweier solcher Generatoren zueinander sowie eine entsprechende Beschaltung.

Wellenenergiekonverter sind im Stand der Technik allgemein bekannt. Die den Oberflächenwellen von Gewässern, insbesondere offener Meere, inhärente kinetische Energie wird hierbei auf verschiedene Weise in elektrische Energie umgewandelt. Beispielsweise sind hydraulische Pumpsysteme zum Antrieb elektrischer Generatoren bekannt.

Aus der Druckschrift DE 60 2004 008 639 T2 ist ein Wellenenergiewandler bekannt, bei welchem ein Schwimmkörper ein Verbindungselement trägt, das mit dem Wellengang auf- und abgleitet und entsprechend elektrische Energie in einer das Verbindungselement umgebenden Spule erzeugt.

Ein Nachteil der bekannten Wellenenergietransformer ist ihr relativ komplexer und materialintensiver Aufbau, der gemäß der Vorrichtung nach DE 60 2004 008 639 T2 einen hohen Aufwand an Kupferspulen erfordert.

Aus der Druckschrift EP 1 212 800 D1 ist darüber hinaus ein Generator zum Umwandeln mechanischer Energie in elektrische Energie bekannt, bei dem wenigstens zwei Elektroden in einem Polymer in einer Weise angeordnet sind, dass eine Veränderung des elektrischen Feldes als Reaktion auf eine auf einem ersten Teil des Polymers aufgebrachte Auslenkung auftritt. Ferner sind unterschiedliche Aufbauten und Anordnungen der Elektroden in Bezug auf das elektroaktive Polymermaterial bekannt, wobei unter anderem ein Stapeln von elektroaktiver Polymerfolie zu einem effektiveren Kondensator mit variabler Kapazität vorgeschlagen wird.

WO 2011/105913 A1, US 2011/0298215 A1 und WO 01/65615 A2 zeigen jeweils zwei Generatoren, die gegenläufig von einem Aktuator ausgelenkt werden.

Aufgabe der Erfindung ist es, eine Vorrichtung zur Umwandlung mechanischer Energie in elektrische Energie zur Verfügung zu stellen, bei welcher die Leistungselektronik kleiner und kostengünstiger als bei bekannten Systemen dimensioniert werden kann.

Eine weitere Aufgabe der vorliegenden Erfindung ist es, eine Vorrichtung zur Umwandlung mechanischer Energie in elektrische Energie zur Verfügung zu stellen, bei welcher Auswirkungen mechanischer Nichtlinearitäten im Polymer vermindert werden.

### Offenbarung der Erfindung

Die vorstehend genannten Aufgaben wird durch eine Vorrichtung mit den Merkmalen nach Anspruch 1 sowie ein Verfahren zum Betrieb einer solchen Vorrichtung mit den Merkmalen nach Anspruch 9 gelöst. Erfindungsgemäß weist die Vorrichtung einen ersten Generator und einen zweiten Generator auf, welche jeweils elektrische Elektroden und ein elektroaktives Polymer umfassen. Solche Generatoren können eine direkte Umwandlung mechanischer Energie in elektrische Energie durchführen, indem die Elektroden der Generatoren mit einer ersten Spannung beaufschlagt werden, im Ansprechen worauf eine mechanisch induzierte Veränderung der Elektrodenanordnung zu einer Änderung ihrer Kapazität führt. Dies kann insbesondere durch eine Veränderung des Abstandes der Elektroden eines Generators voneinander sowie alternativ oder zusätzlich durch eine Veränderung der wirksamen Elektrodenflächen eines Generators erfolgen. Die Energiegewinnung basiert dabei auf der Abfolge von vier sequenziellen Schritten: In einer ersten Phase wird der Generator, bestehend aus einem zwischen zwei nachgiebigen Elektroden eingebrachten Polymer, aufgrund einer äußeren Krafteinwirkung verformt, wobei die elektrische Kapazität der Anordnung zunimmt. In einem zweiten Schritt wird bei maximaler Verformung des Generators die Elektrodenanordnung mit einer elektrischen Spannung beaufschlagt. In einer dritten Phase wird bei Verringerung der äußeren Kraft der Generator relaxiert, wodurch die Elektroden einen größeren Abstand zueinander annehmen und/oder ihre wirksame Elektrodenfläche sich verringert, wobei sich die elektrische Kapazität der Anordnung verringert. Hierbei erhöht sich die im Generator gespeicherte elektrische Energie, wodurch eine Wandlung von mechanischer in elektrische Energie erfolgt. In einer vierten Phase wird nach einer vollständigen Relaxation, also in einem Zustand maximalen Abstandes der Elektroden des Generators, die Anordnung elektrisch entladen, wobei die gewonnene Energie elektrisch freigegeben wird. Wenn im Rahmen der vorliegenden Erfindung von elektrischen Elektroden und einem elektroaktiven Polymer die Rede ist, so sei hierunter auch eine Verwendung von elektrisch leitfähigen Abschnitten des elektroaktiven Polymers selbst als elektrische Elektroden ebenso umfasst wie eine separate Anordnung von elektrischen Elektroden und einem zwischen diesen liegenden elektroaktiven Polymer. Zusätzlich umfasst die erfindungsgemäße Vorrichtung einen Aktuator zur Einbringung mechanischer Energie im ersten Generator und im zweiten Generator, wobei der Aktuator eine Kompression der elektroaktiven Polymere des ersten Generators und des zweiten Generators ermöglicht. Im einfachsten Fall kann der Aktuator daher die Gestalt einer Platte haben, welche zur Einleitung einer entsprechenden Druck- und/oder Zugkraft eingerichtet ist. An einen solchen Aktuator kann beispielsweise ein Schwimmkörper gekoppelt werden, welcher durch den Wellengang an der Meeresoberfläche Druck- bzw. Zugkräfte auf den Aktuator ausübt. Zusätzlich umfasst eine erfindungsgemäße Vorrichtung eine Leistungselektronik, durch welche die Elektroden eines Generators mit einer elektrischen Spannung beaufschlagt werden können, welche - wie oben beschrieben - im Ansprechen auf das Einwirken mechanischer Energie erhöht wird. Erfindungsgemäß sind die beiden Generatoren der Vorrichtung derart angeordnet, dass im Ansprechen auf eine Verschiebung, z.B. durch eine Weg- und/oder Kraftanregung des Aktuators, das elektroaktive Polymer des ersten Generators mit einer Druckkraft beaufschlagt wird, während das elektroaktive Polymer des zweiten Generators mit einer Zugkraft beaufschlagt wird. Mit anderen Worten kann sich für eine periodische Aktuatorverschiebung eine Phasenverschiebung zwischen entsprechenden Zuständen des ersten und des zweiten Generators von 180° ergeben.

Die Unteransprüche zeigen bevorzugte Weiterbildungen der Erfindung.

Vorzugsweise können der erste Generator und der zweite Generator bzw. das elektroaktive Polymer und die elektrischen Elektroden des ersten Generators sowie das elektroaktive Polymer und die elektrischen Elektroden des zweiten Generators zueinander derart angeordnet sein, dass die durch den Aktuator eingeleitete Kraft jeweils im Wesentlichen entlang einer gemeinsamen Achse verläuft. Hierdurch ergibt sich eine mechanisch besonders einfache und kompakte Anordnung für die erfindungsgemäße Vorrichtung.

Weiter bevorzugt kann die erfindungsgemäße Vorrichtung nach Art eines Stapels aus elektroaktiven (Polymeren und elektrischen Elektroden sowohl des ersten Generators als auch des zweiten Generators aufgebaut sein. Mit anderen Worten ergibt sich eine geschichtete Anordnung, in deren Mitte der Aktuator angeordnet sein kann, dessen Auslenkung in eine erste Richtung zu einer Kompression des elektroaktiven Polymers des ersten Generators führt, während gleichzeitig das elektroaktive Polymer des zweiten (auf der gegenüberliegenden Seite des Aktuators befindlichen) Polymers des zweiten Generators expandiert wird. Neben dem Vorteil einer kompakten Anordnung für die erfindungsgemäße Vorrichtung können auf diese Weise nichtlineare, mechanische Effekte bei der Dehnung/Expansion eines Generators von demjenigen eines zweiten Generators kompensiert werden, wodurch eine zusätzliche mechanische oder elektrische Kompensation nicht erforderlich ist.

Weiter bevorzugt können der erste und der zweite Generator der erfindungsgemäßen Vorrichtung eingerichtet sein, im Ansprechen auf eine über den Aktuator eingeleitete Verschiebung den Abstand zwischen Elektroden des ersten Generators zu vergrößern und gleichzeitig den Abstand zwischen Elektroden des zweiten Generators zu verringern und alternativ bereits zusätzlich hierzu im Ansprechen auf eine über den Aktuator eingeleitete Verschiebung die Flächen der Elektroden des ersten Generators zu vergrößern und dabei die Flächen der Elektroden des zweiten Generators zu verringern. Hierzu weisen die Generatoren verformbare Elektroden auf, welche beispielsweise als metallische Dünnschicht, metallisches Gewebe, eine Ansammlung metallischer Partikel, welche zu einem Mindestmaß in elektrischem Kontakt zueinander stehen, ausgeführt sein können. Indem die Elektroden bei einem ersten (kleineren) Abstand voneinander eine größere effektive Fläche aufweisen, als in einem zweiten (größeren) Abstand zueinander, ergibt sich eine vorteilhafte Veränderung der Kapazität der Elektrodenanordnung, welche das mögliche Maß an Energiegewinnung bei gleichbleibendem Hub zwischen den Elektroden begünstigt.

Weiter umfasst die Leistungselektronik der erfindungsgemäßen Vorrichtung eine Zwischenkreiskapazität, welche zwischen einer Spannungsversorgung und den Generatoren angeordnet ist. Mittels eines ersten Schalters ist die Zwischenkreiskapazität eingerichtet, zumindest einen Teil der Energie des ersten Generators aufzunehmen und mittels eines dritten Schalters zumindest einen Teil der aufgenommenen Energie in Form elektrischer Spannung auf die Elektroden des zweiten Generators zu übertragen. Hierzu kann der erste Schalter beispielsweise dann geschlossen werden, wenn die Elektroden des ersten Generators einen maximalen Abstand zueinander aufweisen, wodurch die Zwischenkreiskapazität geladen wird. Bei einer Phasenverschiebung von 180° zwischen dem ersten und dem zweiten Generator befindet sich der zweite Generator nun in einem Zustand, in welchem seine Elektroden einen minimalen Abstand zueinander aufweisen, so dass unter Vermittlung des dritten Schalters ein Teil der Energie zur Ladung des zweiten Generators verwendet werden kann. Bevorzugt ist die Zwischenkreiskapazität dabei ebenfalls im Stande, einen entgegen der vorbeschriebenen Energieübertragungsrichtung verlaufenden Energieübertrag zu unterstützen, also mittels des zweiten Generators aufgenommene Energie zu speichern und zumindest einen Teil der aufgenommenen Energie zur Ladung des ersten Generators bzw. dessen elektrischer Elektrode bereitzustellen. Indem innerhalb der Vorrichtung erzeugte Energie ortsnah und mit geringem zeitlichem Verzug zumindest zu einem Teil zur weiteren Energieerzeugung verwendet wird, kann die Zwischenkreiskapazität deutlich kleiner als bei herkömmlichen (isolierten) Generatoren ausfallen oder (insbesondere bei Verwendung hinreichend vieler und lediglich geringfügig gegeneinander phasenverschobener Generatoren) sogar gänzlich entfallen. Weiter sind die zum Laden und Entladen benötigten Spitzenströme gegenüber den bekannten Anordnungen lediglich halb so groß. Hierdurch können kleinere Schalter verwendet werden und die stromabhängigen Verluste sind geringer.

Weiter bevorzugt umfasst die Leistungselektronik einen Wandler mit einer ersten Induktivität und einer zweiten Induktivität. Die erste Induktivität ist dabei mit dem ersten Generator bzw. dessen variabler Kapazität in Reihe geschaltet, während die zweite Induktivität mit dem zweiten Generator bzw. dessen variabler Kapazität in Reihe geschaltet ist. Mittels dieser Induktivitäten kann beispielsweise beim Ladevorgang im Zustand minimal beabstandeter Generatorelektroden die durch die Versorgungsspannung bereit gestellte Ladungsmenge erhöht werden. Hierbei ist es vorteilhaft, die erste Induktivität und die zweite Induktivität einerseits an die Kapazität des ersten Generators und des zweiten Generators im Falle minimal beabstandeter Elektroden anzupassen, andererseits auch die mittlere Frequenz der Verschiebung des Aktuators zu berücksichtigen. Hierdurch ergeben sich geringere, durch die Versorgungsspannung zur Verfügung zu stellende Spannungen bzw. eine höhere Leistungsfähigkeit der Generatoren bei festgehaltener Geometrie. Zudem ermöglichen es die Induktivitäten, die ohmschen Leitungsverluste zu reduzieren, indem die Spitzenströme während des Ladungswechsels reduziert werden.

Weiter vorteilhaft kann das elektroaktive Polymer der Generatoren im Ruhezustand vorgespannt sein, um einen Arbeitspunkt zu erzeugen, welcher im Wesentlichen symmetrisch zu den Grenzen des Arbeitsbereiches der Generatoren liegt. Beispielsweise kann das Polymer beider Generatoren im Ruhezustand ungefähr um die Hälfte der im Betrieb zu erwartenden mechanischen Belastung vorgespannt sein. In Abhängigkeit der Materialparameter und der Anregungsfunktionen kann somit ein symmetrischer Arbeitspunkt zwischen maximal zu erwartenden Druck- und Zugspannungsbelastungen eingestellt werden, um Auswirkungen von Nichtlinearitäten in den Steifigkeitscharakteristiken beider Generatoren zu kompensieren.

Gemäß einem weiteren Aspekt der vorliegenden Erfindung wird ein Verfahren zum Betrieb einer Vorrichtung nach einem der vorstehenden Ansprüche vorgeschlagen, gemäß welchem im Ansprechen auf ein Erreichen eines ersten vordefinierten Abstands elektrischer Elektroden des Generators voneinander die Elektroden mit einer elektrischen Spannung beaufschlagt werden. Dieser erste vordefinierte Abstand der elektrischen Elektroden kann beispielsweise ein minimaler Abstand sein, welcher sich z. B. bei periodischer Anregung dadurch ermitteln lässt, dass bei einer Bewegung der Elektroden des ersten Generators zueinander die Bewegungsgeschwindigkeit geringer wird und schließlich zu "0" wird. Anschließend kann bei Erreichen eines zweiten vordefinierten Abstandes der Elektroden des ersten Generators voneinander elektrische Energie aus dem ersten Generator entnommen werden. Dieser zweite vordefinierte Abstand der elektrischen Elektroden kann beispielsweise ein maximaler Abstand der elektrischen Elektroden voneinander sein, welcher beispielsweise auch ermittelt werden kann, indem der Zeitpunkt ermittelt wird, zu welchem bei einer Bewegung der beiden Elektroden voneinander die Bewegungsgeschwindigkeit abnimmt und schließlich zu "0" wird. Mit anderen Worten können der erste vordefinierte Abstand und der zweite vordefinierte Abstand als oberer und unterer Totpunkt aufgefasst und ermittelt werden. Zumindest ein Teil der während des zweiten vordefinierten Abstands der elektrischen Elektroden entnommenen elektrischen Energie aus dem ersten Generator kann dabei zur Beaufschlagung von Elektroden des zweiten Generators mit einer elektrischen Spannung verwendet werden. Die Feststellung, zu welchem Zeitpunkt der erste vordefinierte Abstand und der zweite vordefinierte Abstand zwischen den Elektroden des ersten Generators bestehen, kann auf viele verschiedene Weisen und unter Verwendung unterschiedlicher physikalischer Prinzipien erfolgen, welche vom Einsatzgebiet und dem Aufbau der Vorrichtung abhängen, ohne den Fachmann dabei vor Probleme zu stellen, so dass auf eine detaillierte Diskussion derselben hier verzichtet werden kann.

Gemäß einem weiteren Aspekt der vorliegenden Erfindung wird eine Anlage zur Gewinnung elektrischer Energie aus Wellenenergie zur Verfügung gestellt. Diese umfasst eine Verankerungsvorrichtung zur mechanischen Festlegung der Anlage im Bereich eines Gewässers, insbesondere eines maritimen Gewässers. Beispielsweise kann die Verankerungsvorrichtung an der Küste oder unterseeisch bzw. am Meeresboden angeordnet sein. Zusätzlich umfasst die Anlage eine Vorrichtung, wie sie im Detail oben beschrieben worden ist. Zur Bewegung des Aktuators kann ein Schwimmkörper vorgesehen sein, welcher eingerichtet ist, alternierende Auftriebskräfte zu erfahren, wenn er den Wellen ausgesetzt ist. Zur Übertragung der mechanischen Wechselkräfte kann der Schwimmkörper über eine starre Verbindung mit dem Aktuator der Vorrichtung verbunden sein. Wirken auf den Schwimmkörper alternierende Auftriebskräfte, weil dieser sich in den Wellen auf und ab bewegt, überträgt die Verbindung die entstehenden Wechselkräfte auf die Vorrichtung, in welcher elektrische Energie erzeugt wird. Alternativ oder zusätzlich kann die Vorrichtung selbstverständlich auch innerhalb des Schwimmkörpers angeordnet werden, wobei in diesem Fall die Vorrichtung eine ortsfeste Verbindung z.B. zum Meeresboden aufweisen muss, um nennenswerte Wechselkräfte zu erfahren.

### Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:
- Figur 1a bis 1b: eine Illustration unterschiedlicher Zustände eines Generators mit elektrischen Elektroden und einem elektroaktiven Polymer;
- Figur 2: eine schematische Darstellung eines Ausführungsbeispiels gemäß der vorliegenden Erfindung;
- Figur 3: ein Schaltplan für den Betrieb eines Generators mit elektrischen Elektroden und einem elektroaktiven Polymer;
- Figur 4-7: Schalt- und Stromflusszustände der elektrischen Schaltung au Figur 3 beim Aufladen, Nachladen Entladen eines EAP Generators sowie beim Rückspeisen der elektrischen Energie aus dem EAP Generator C_{L};
- Figur 8: ein Schaltplan für eine Schaltung zum Betrieb eines Ausführungsbeispiels der vorliegenden Erfindung;
- Figur 9: eine schematische Ansicht eines Anwendungsbeispiels für ein Ausführungsbeispiel gemäß der vorliegenden Erfindung.

### Ausführungsformen der Erfindung

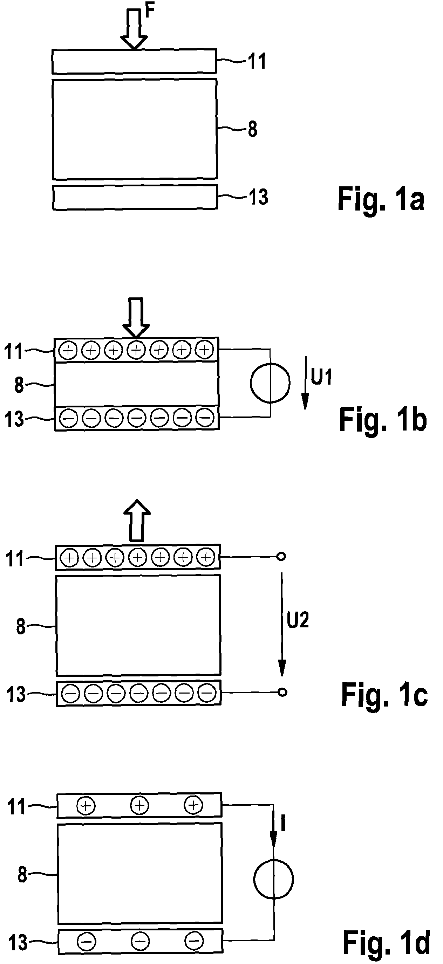

Die Figuren 1a bis 1d zeigen eine schematische Sequenz zur Energiegewinnung mittels elektroaktiver Polymere in einer Anordnung gemäß dem Stand der Technik. In Figur 1a wird das elektroaktive Polymer 8, welches zwischen zwei Elektroden 11, 13 angeordnet ist, durch eine Kraft F komprimiert. Die elektrische Kapazität der in der Figur 1a dargestellten Anordnung vergrößert sich hierdurch.

Figur 1 b zeigt die in Figur 1 a dargestellte Anordnung nach vollendeter Kompression. Zusätzlich ist eine Spannung U1 zwischen den Elektroden 11, 13 angelegt.

In Figur 1 c ist die in Figur 1 b dargestellte Anordnung expandiert, wodurch die elektrische Kapazität der Anordnung abgenommen hat. Da nach erfolgter Ladung der Anordnung in Figur 1 b die Anordnung von der Versorgungsspannung U₁ getrennt worden ist, hat sich in Figur 1c der Ladungszustand der Elektroden 11, 13 nicht verändert. Aufgrund der verringerten Kapazität ist jedoch die Spannung U₂ und somit die in der Anordnung gespeicherte elektrische Energie gestiegen. In Figur 1d wird die in elektrischer Form gewonnene Energie in Form eines Stromflusses "geerntet". Nach erfolgter Entleerung der Anordnung könnte durch Aufbringen einer Kraft F der in Figur 1a dargestellte Zustand hergestellt und der Verfahrensablauf von neuem begonnen werden.

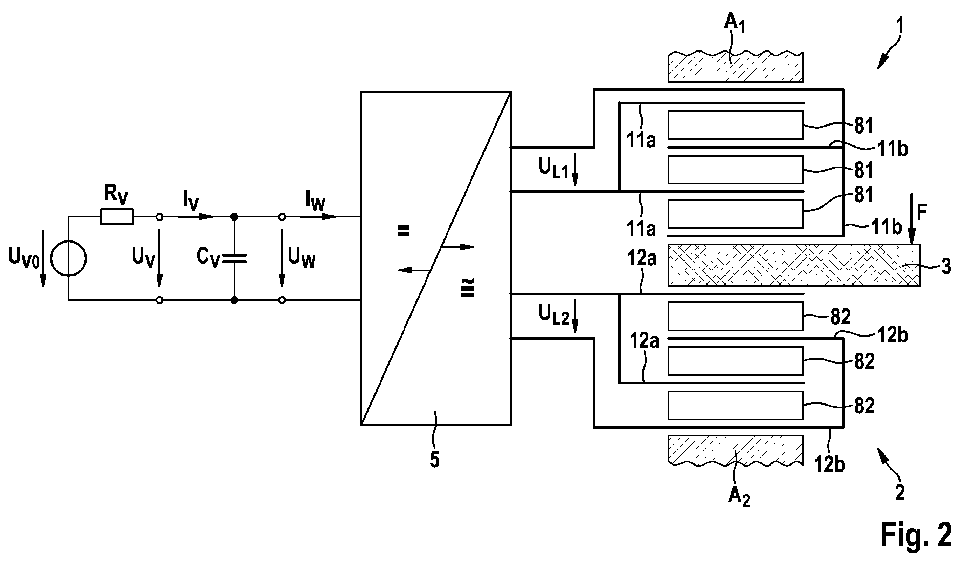

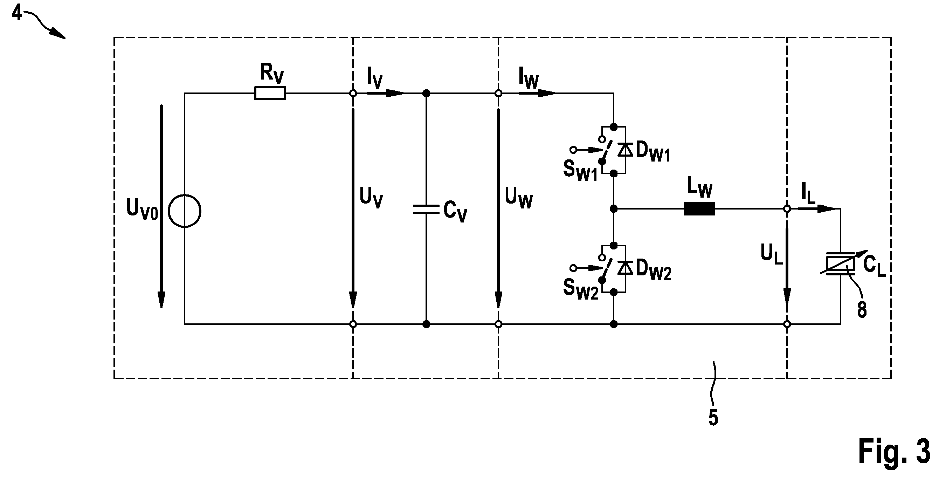

Figur 2 zeigt eine schematische Anordnung eines Ausführungsbeispiels einer erfindungsgemäßen Vorrichtung. Ein erster Generator 1 umfasst drei Pakete elektroaktiver Polymere 81, zwischen denen Elektroden angeordnet sind. Erste Elektroden 11a sind mit einem ersten Anschluss eines Wechselrichters 5 verbunden. Jeweils zwischen zwei ersten Elektroden 11a ist eine erste Elektrode 11 b angeordnet, welche mit einem zweiten Anschluss des Wechselrichters 5 verbunden sind. Unterhalb des ersten Generators 1 ist ein Aktuator 3 zur Einleitung einer Kraft F angeordnet. Unterhalb des Aktuators 3 ist ein zweiter Generator 2, umfassend ebenfalls drei elektroaktive Polymerpakete 82 und - ebenso wie beim ersten Generator 1 - abwechselnd zueinander und mit unterschiedlichen Anschlüssen des Wechselrichters 5 verbundene erste Elektroden 12a und zweite Elektroden 12b vorgesehen. Die Anordnung aus erstem Generator 1 und zweitem Generator 2 wird zwischen zwei Ankern A₁, A₂ mechanisch festgelegt, um eine Kraftwirkung auf den Aktuator 3 zu ermöglichen. Der Wechselrichter ist einerseits zur Versorgung der Generatoren mit elektrischer Energie vorgesehen, führt gleichzeitig jedoch auch die Abfuhr der erzeugten elektrischen Energie aus den Generatoren 1, 2 durch. An dem den Generatoren 1, 2 gegenüberliegenden Eingang ist eine Zwischenkreiskapazität Cᵥ parallel geschaltet und eine Versorgungsspannung Uᵥ in Form einer Versorgungsquellspannung Uᵥ₀ und eines Vorwiderstandes Rᵥ umfassenden Spannungsquelle bereitgestellt. Auf die elektrischen Vorgänge innerhalb des Wechselrichters 5 wird in Verbindung mit den Figuren 3 bis 8 im Folgenden näher eingegangen.

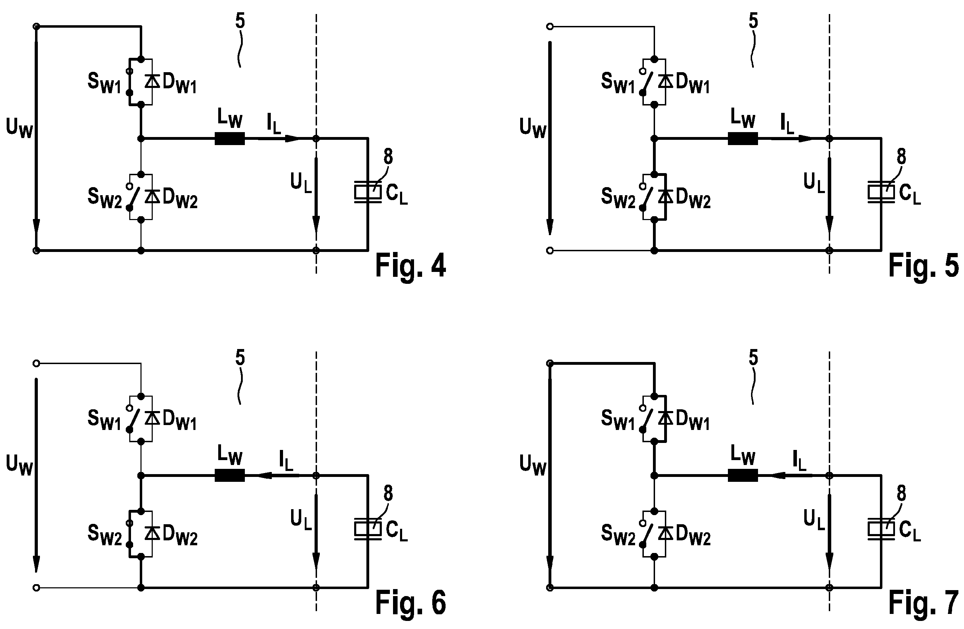

Figur 3 zeigt eine Schaltungsanordnung für den Betrieb eines EAP-Generators gemäß dem Stand der Technik. Eine Versorgungsspannung Uᵥ wird durch eine Spannungsquelle Uᵥ₀ und ihren Vorwiderstand Rᵥ zur Verfügung gestellt. Diese liegt parallel zu einer Zwischenkreiskapazität Cᵥ und dem Eingang eines Wandlers 5. Hinter dem Eingang des Wandlers 5 sind zwei in Reihe angeordnete Schalter S_{w1} und S_{w2} zwischen den Eingangsklemmen des Wandlers 5 angeordnet. Parallel zu den Schaltern S_{w1} und S_{w2} ist jeweils eine Diode D_{w1}, D_{w2} in Sperrrichtung zur Versorgungsspannung Uᵥ angeordnet. Zwischen den Schaltern S_{w1} und S_{w2} ist eine Induktivität L_{w} mit einer Ausgangsklemme des Wandlers 5 verbunden. Zwischen dieser Ausgangsklemme und dem Bezugspotential ist eine variable Kapazität C_{L} umfassend ein elektroaktives Polymer 8 zur Energieerzeugung angeordnet. Wird der Schalter S_{w1} geschlossen, während die variable Kapazität einen hohen Wert hat (korrespondierend zu einem kleinen Abstand ihrer Elektroden), so kann die Versorgungsspannung Uᵥ über den Schalter S_{w1} und die Induktivität L_{w} Ladung auf die variable Kapazität C_{L} aufbringen. Dieser Zustand ("Aufladen") ist in Figur 4 dargestellt, in welcher die fett dargestellte Linie den Pfad des Stromflusses hervorhebt. In Figur 5 ist das sogenannte "Nachladen" visualisiert, wobei nach dem Öffnen des Schalters S_{w1} die im Magnetfeld der Spule L_{w} gespeicherte Energie einen Stromfluss über die Diode D_{w2} erzwingt und die elektrische Spannung des EAP-Generators weiter erhöht. Wird nun das elektroaktive Polymer 8 expandiert (zwischen den in Figur 5 und Figur 6 gezeigten Zuständen), so steigt die Spannung U_{L}, wodurch ein mechanisch induzierter Energiegewinn erfolgt. Um die im EAP-Generator erzeugte Energie in der Spannungsquelle zu "ernten", wird die Energie durch Schließen des Schalters S_{w2} zumindest anteilig in das Magnetfeld der Spule L_{w} übertragen. Anschließend wird der Schalter S_{w2} geöffnet, im Ansprechen worauf die Spule L_{w} den Stromfluss nun entgegen der Versorgungsspannung U_{w} treibt und dabei Ladung über die Diode D_{w1} auf die Zwischenkapazität Cᵥ gebracht wird.. Auf diese Weise erfolgt eine Energierückspeisung aus dem EAP-Generator in die elektrische Schaltung. In Zusammenhang mit den Schaltvorgängen zur Ansteuerung der bekannten Schaltung wird auf Stiebel, C: "Leistungsverstärker zur verlustarmen Ansteuerung von kapazitiven Lasten", Dissertation an der Universität des Saarlandes, Shaker Verlag, 2002, verwiesen.

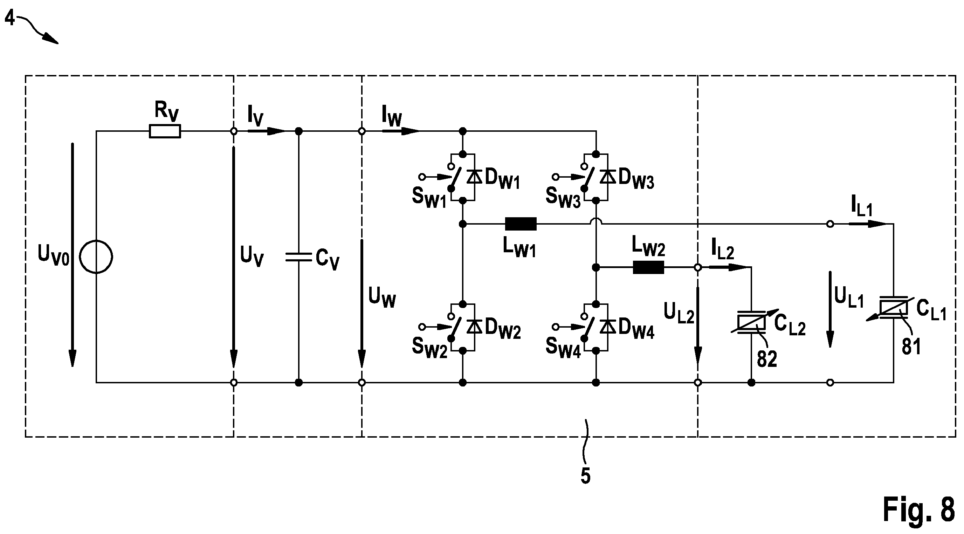

Figur 8 zeigt eine erfindungsgemäße Schaltung, wie sie für den Einsatz einer erfindungsgemäßen Vorrichtung, ausgehend von der in Figur 3 gezeigten Schaltung, modifiziert worden ist. Um Ladung von der ersten variablen Kapazität C_{L1} umfassend das erste elektroaktive Polymer 81 über die Zwischenkapazität Cᵥ und von dieser anschließend auf die zweite variable Kapazität C_{L2} umfassend das zweite elektroaktive Polymer 82 zu transferieren, ist die in Figur 3 dargestellte Schaltung um zwei weitere Schalter S_{w3} und S_{w4} mit jeweiligen parallelen und in Sperrichtung zur Versorgungsspannung Uᵥ geschalteten Dioden D_{w3} und D_{w4} sowie eine weitere Induktivität L_{w2} erweitert worden. Mit anderen Worten wurde der aus den Schaltern S_{w1} und S_{w2} bestehende Zweig, welcher über die erste Induktivität L_{w1} mit der ersten variablen Kapazität C_{L1} verbunden ist, durch eine Parallelschaltung einer weiteren Reihenschaltung aus einem dritten Schalter S_{w3} und einem vierten Schalter S_{w4}, welche jeweils eine parallele Diode D_{w3} bzw. D_{w4} aufweisen, erweitert. Die zusätzliche (zweite) Induktivität L_{w2} ist mit einem ersten Anschluss zwischen den dritten Schalter S_{w3} und den vierten Schalter S_{w4} und mit einem zweiten Anschluss an eine zweite Ausgangsklemme des Wandlers 5 geschaltet. An dieser Ausgangsklemme ist die zweite variable Kapazität C_{L2} angeschlossen und andererseits mit dem Bezugspotential der Versorgungsspannung Uᵥ verbunden. Die Schaltvorgänge der Schalter S_{w1} und S_{w2} in Verbindung mit der ersten variablen Kapazität C_{L1} bzw. der Schalter S_{w3} und S_{w4} in Verbindung mit der zweiten variablen Kapazität C_{L2} entsprechen jeweils denjenigen, wie sie unter Bezugnahme auf Figur 3 für die Schalter S_{w1} und S_{w2} in Verbindung mit nur einer variablen Kapazität C_{L} beschrieben worden sind. Grundsätzlich kann die nach der Expansion des elektroaktiven Polymers 81 in der ersten variablen Kapazität C_{L1} vorhandene Energie bei geschlossenem zweitem Schalter S_{w2} in die Spule L_{w1} und nach dem Öffnen des Schalters S_{w2} wie oben beschrieben über die Kapazität Cᵥ in die Spannungsquelle gespeist werden. Aufgrund der Phasenverschiebung zwischen dem ersten elektroaktiven Polymer 81 und dem zweiten elektroaktiven Polymer 82 kann ein Teil der vom ersten elektroaktiven Polymer 81 gelieferten Energie (bzw. Ladung) zur Ladung des zweiten elektroaktiven Polymers 82 über den geschlossenen dritten Schalter S_{w3} verwendet werden. Daher muss die Zwischenkreiskapazität Cᵥ nicht die gesamte hierbei transportierte Ladung zwischenspeichern können. Somit kann ihre Kapazität geringer ausfallen. Umgekehrt ergibt sich ein entsprechendes Szenario, in welchem die zweite variable Kapazität C_{L2} nach der Expansion ihres elektroaktiven Polymers 82 einen Teil der in ihm gespeicherten Energie bzw. Ladung über die Diode D_{w3} und einen geschlossenen Schalter S_{w1} bei offenen Schaltern S_{w2} und S_{w4} über die erste Induktivität L_{w1} auf die erste variable Kapazität C_{L1} überträgt. Die dargestellten Elemente der Schaltungsanordnung werden im Wesentlichen entsprechend der Phasenverschiebung zwischen den jeweils zugehörigen EAP-Generatoren angesteuert bzw. mit Strom und/oder Spannung beaufschlagt. Diese Vorgänge entsprechen im Wesentlichen den in Verbindung mit den Fign. 3, 4, 5, 6 und 7 diskutierten. Zusätzlich wird auch in Zusammenhang mit den Schaltvorgängen auf Stiebel, C: "Leistungsverstärker zur verlustarmen Ansteuerung von kapazitiven Lasten", Dissertation an der Universität des Saarlandes, Shaker Verlag, 2002, verwiesen.

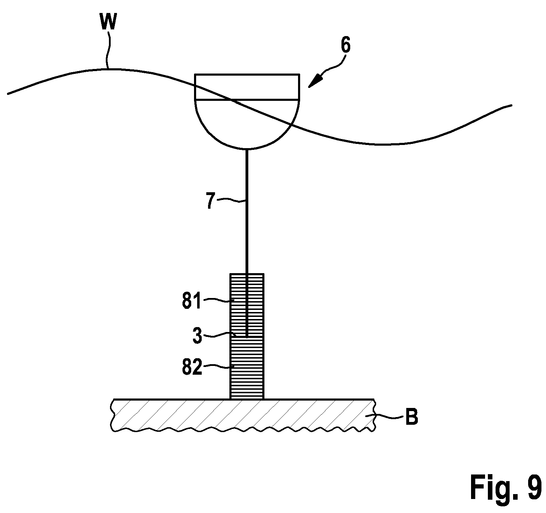

Figur 9 zeigt eine Prinzipskizze einer möglichen Anwendung eines Ausführungsbeispiels der vorliegenden Erfindung. Am Boden B eines Gewässers ist eine das erste elektroaktive Polymer 81 und zweite elektroaktive Polymer 82 und den Aktuator 3 umfassende erfindungsgemäße Vorrichtung verankert, wie sie oben im Detail beschrieben worden ist. Der Aktuator 3 ist über einen Stab 7 als Verbindung mit einem Schwimmkörper 6 verbunden, der dem Wellengang der Wellen W ausgesetzt ist. In Abhängigkeit seiner Position zur aktuellen Wasseroberfläche erfährt der Schwimmkörper 6 höhere oder niedrigere Auftriebskräfte und überträgt diese über die Stange 7 an den Aktuator 3. Über den Aktuator 3 wird bei höherem lokalem Wasserstand über der Vorrichtung eine Druckkraft auf das erste elektroaktive Polymer 81 und eine Zugkraft auf das zweite elektroaktive Polymer 82 ausgeübt, wodurch bei entsprechender elektrischer Ansteuerung (nicht gezeigt) der Elektroden der Vorrichtung elektrische Energie gewonnen werden kann. Entsprechend wird über den Aktuator 3 bei niedrigem lokalem Wasserstand über der Vorrichtung eine Zugkraft auf das erste elektroaktive Polymer 81 und eine Druckkraft auf das zweite elektroaktive Polymer 82 ausgeübt. Indem die auftretenden Kräfte jeweils gegenläufig und bevorzugt dem Betrage nach gleich sind, kompensieren sich die Auswirkungen nichtlinearer Vorgänge in den Generatoren.

Es ist ein Kerngedanke der vorliegenden Erfindung, durch geeignete mechanische und elektrische Verschaltung zweier oder mehrerer EAP-Generatoren, welche in Differenz betrieben werden, eine kleinere und kostengünstigere Dimensionierung der Bestandteile der notwendigen Leistungselektronik zu ermöglichen. Hierbei sind mindestens zwei Stapel elektroaktiver Polymere 81, 82 einem Aktuator 3 zugeordnet, wodurch sich eine Ladung eines zweiten elektroaktiven Polymers 82 unter Vermittlung mit dem ersten elektroaktiven Polymer 81 erzeugter Energie durchführen lässt. Die Dimensionen der hierzu erforderlichen Bauteile können daher gegenüber dem Stand der Technik auf ein Mindestmaß reduziert werden, und Nichtlinearitäten gegen Steifigkeitscharakteristiken beider Generatoren kompensieren sich.

Auch wenn die Erfindung anhand detaillierter Zeichnungen und Ausführungsbeispiele veranschaulicht worden ist, so sind für den Fachmann zahlreiche Modifikationen und insbesondere Kombinationen zwischen dargestellten und diskutierten Ausführungsbeispielen möglich, welche sämtlich als im Bereich der vorliegenden Erfindung liegend zu erachten sind, deren Schutzbereich durch die beigefügten Ansprüche definiert wird.

## Patentansprüche

1. Vorrichtung zur Umwandlung mechanischer Energie in elektrische Energie, umfassend:
- einen ersten Generator (1) mit elektrischen Elektroden (11 a, 11 b) und einem elektroaktiven Polymer (81),
- einen zweiten Generator (2) mit elektrischen Elektroden (12a, 12b) und einem elektroaktiven Polymer (82),
- einen Aktuator (3) zur Einbringung mechanischer Energie in den ersten Generator (1) und in den zweiten Generator (2),
- eine Leistungselektronik (4) zur Beaufschlagung der Elektroden (11 a, 11 b; 12a, 12b) mit einer elektrischen Spannung (U_{L1}, U_{L2}),
wobei das elektroaktive Polymer (81) des ersten Generators (1) eingerichtet ist, im Ansprechen auf eine Verschiebung des Aktuators (3) mit einer Druckkraft beaufschlagt zu werden und das elektroaktive Polymer (82) des zweiten Generators (82) eingerichtet sind, im Ansprechen auf die Verschiebung mit einer Zugkraft beaufschlagt zu werden,
**dadurch gekennzeichnet,**
**dass** die Leistungselektronik (4) eine Zwischenkreiskapazität (Cᵥ) umfasst, wobei die Zwischenkreiskapazität (Cᵥ) eine mittels des zweiten Generators (2) aufgenommene Energie speichert und zumindest eine Teil der aufgenommenen Energie zur Ladung des ersten Generators (1) bereitstellt.

2. Vorrichtung nach Anspruch 1, wobei der erste Generator (1) und der zweite Generator (2) derart zueinander angeordnet sind, dass die Druckkraft und die Zugkraft im Wesentlichen entlang einer gemeinsamen Achse verlaufen.

3. Vorrichtung nach Anspruch 1 oder 2, wobei
- die elektrischen Elektroden (11 a, 11 b; 12a, 12b) und die elektroaktiven Polymere (81, 82) im Wesentlichen entlang einer gemeinsamen Achse angeordnet sind, und
- der Aktuator (3) eingerichtet ist, die mechanische Energie zwischen dem elektroaktiven Polymer (81) des ersten Generators (1) und dem elektroaktiven Polymer (82) des zweiten Generators (2) einzuleiten.

4. Vorrichtung nach einem der vorstehenden Ansprüche, wobei der erste und der zweite Generator (2) eingerichtet sind, im Ansprechen auf eine Verschiebung des Aktuators (3) den Abstand zwischen Elektroden (11 a, 11 b) des ersten Generators (1) zu vergrößern und gleichzeitig den Abstand zwischen Elektroden (12a, 12b) des zweiten Generators (2) zu verringern, und/oder wobei der erste Generator (1) und der zweite Generator (2) verformbare Elektroden (11 a, 11 b; 12a, 12b) umfassen, wobei der erste Generator (1) und der zweite Generator (2) eingerichtet sind, im Ansprechen auf eine Verschiebung des Aktuators (3) eine Fläche einer Elektrode (11 a, 11 b) des ersten Generators (1) zu vergrößern und dabei eine Fläche einer Elektrode (12a, 12b) des zweiten Generators (2) zu verringern.

5. Vorrichtung nach einem der vorstehenden Ansprüche, wobei die Zwischenkreiskapazität (Cᵥ)
- mittels eines ersten Schalters (S_{w1}) eingerichtet ist, zumindest einen Teil der Energie des ersten Generators (1) aufzunehmen und weiter mittels eines dritten Schalters (S_{w3}) eingerichtet ist, zumindest einen Teil der aufgenommenen Energie des ersten Generators (1) als elektrische Spannung auf die Elektroden (12a, 12b) des zweiten Generators (2) zu übertragen, und
- mittels des dritten Schalters (S_{w3}) eingerichtet ist, zumindest einen Teil der Energie des zweiten Generators (2) aufzunehmen und weiter mittels des ersten Schalters (S_{w1}) eingerichtet ist, zumindest einen Teil der aufgenommenen Energie des ersten Generators (2) als elektrische Spannung auf die Elektroden (11 a, 11 b) des ersten Generators (2) zu übertragen.

6. Vorrichtung nach einem der vorstehenden Ansprüche, wobei die Leistungselektronik (4) einen Wandler (5) mit einer ersten Induktivität (L_{w1}) und einer zweiten Induktivität (L_{w2}) umfasst, wobei die erste Induktivität (L_{w1}) mit dem ersten Generator (1) in Reihe geschaltet ist und die zweite Induktivität (L_{w2}) mit dem zweiten Generator (2) in Reihe geschaltet ist.

7. Vorrichtung nach einem der vorstehenden Ansprüche, wobei das elektroaktive Polymer (81, 82) der Generatoren (1, 2) im Ruhezustand ungefähr um die Hälfte der im Betrieb zu erwartenden mittleren mechanischen Belastung oder der im Betrieb zu erwartenden maximalen mechanischen Belastung vorgespannt ist.

8. Anlage zur Gewinnung elektrischer Energie aus Wellenenergie, umfassend:
- eine Verankerungsvorrichtung (A₁, A₂) zur mechanischen Festlegung der Anlage,
- eine Vorrichtung nach einem der vorstehenden Ansprüche 1 bis 7, und
- einen Schwimmkörper (6) zur Bewegung des Aktuators (3) mittels Wellenenergie.

9. Verfahren zum Betrieb einer Vorrichtung nach einem der Ansprüche 1 bis 7, wobei
- im Ansprechen auf ein Erreichen eines ersten vordefinierten Abstands elektrischer Elektroden (11 a, 11 b) des ersten Generators (1) voneinander die Elektroden mit einer elektrischen Spannung beaufschlagt werden,
- im Ansprechen auf ein Erreichen eines zweiten vordefinierten Abstands der elektrischen Elektroden (11 a, 11 b) des ersten Generators (1) voneinander elektrische Energie aus dem ersten Generator (1) entnommen wird, und
- zumindest ein Teil der entnommenen Energie zur Beaufschlagung von Elektroden (12a, 12b) des zweiten Generators (2) mit einer elektrischen Spannung verwendet wird.

10. Verfahren nach Anspruch 9, wobei der erste vordefinierte Abstand ein minimaler Abstand der elektrischen Elektroden (11 a, 11 b) des ersten Generators (1) voneinander ist und/oder der zweite vordefinierte Abstand ein maximaler Abstand der elektrischen Elektroden (11a, 11 b) des ersten Generators (1) voneinander ist.

## Claims

1. Apparatus for converting mechanical energy into electrical energy, comprising:
- a first generator (1) having electrical electrodes (11a, 11b) and an electroactive polymer (81),
- a second generator (2) having electrical electrodes (12a, 12b) and an electroactive polymer (82),
- an actuator (3) for introducing mechanical energy into the first generator (1) and into the second generator (2),
- power electronics (4) for applying an electrical voltage (U_{L1}, U_{L2}) to the electrodes (11a, 11b; 12a, 12b),
the electroactive polymer (81) of the first generator (1) being set up to have a compressive force applied to it in response to a displacement of the actuator (3), and the electroactive polymer (82) of the second generator (82) being set up to have a tensile force applied to it in response to the displacement,
**characterized in that**
the power electronics (4) comprise an intermediate circuit capacitance (Cᵥ), the intermediate circuit capacitance (Cᵥ) storing energy received by means of the second generator (2) and providing at least some of the received energy for charging the first generator (1).

2. Apparatus according to Claim 1, the first generator (1) and the second generator (2) being arranged with respect to one another in such a manner that the compressive force and the tensile force run substantially along a common axis.

3. Apparatus according to Claim 1 or 2,
- the electrical electrodes (11a, 11b; 12a, 12b) and the electroactive polymers (81, 82) being arranged substantially along a common axis, and
- the actuator (3) being set up to introduce the mechanical energy between the electroactive polymer (81) of the first generator (1) and the electroactive polymer (82) of the second generator (2).

4. Apparatus according to one of the preceding claims, the first and second generators (2) being set up to increase the distance between electrodes (11a, 11b) of the first generator (1) and at the same time to reduce the distance between electrodes (12a, 12b) of the second generator (2) in response to a displacement of the actuator (3), and/or the first generator (1) and the second generator (2) comprising deformable electrodes (11a, 11b; 12a, 12b), the first generator (1) and the second generator (2) being set up to increase an area of an electrode (11a, 11b) of the first generator (1) and to reduce an area of an electrode (12a, 12b) of the second generator (2) in response to a displacement of the actuator (3).

5. Apparatus according to one of the preceding claims, the intermediate circuit capacitance (Cᵥ)
- being set up, by means of a first switch (ski) to receive at least some of the energy from the first generator (1) and also being set up, by means of a third switch (S_{w3}), to transmit at least some of the energy received from the first generator (1) to the electrodes (12a, 12b) of the second generator (2) as electrical voltage, and
- being set up, by means of the third switch (S_{w3}), to receive at least some of the energy from the second generator (2) and also being set up, by means of the first switch (S_{w1}), to transmit at least some of the energy received from the first generator (2) to the electrodes (11a, 11b) of the first generator (2) as electrical voltage.

6. Apparatus according to one of the preceding claims, the power electronics (4) comprising a converter (5) with a first inductance (L_{w1}) and a second inductance (L_{w2}), the first inductance (L_{w1}) being connected in series with the first generator (1) and the second inductance (L_{w2}) being connected in series with the second generator (2).

7. Apparatus according to one of the preceding claims, the electroactive polymer (81, 82) of the generators (1, 2) in the quiescent state being prestressed approximately by half the average mechanical loading to be expected during operation or by half the maximum mechanical loading to be expected during operation.

8. Installation for obtaining electrical energy from wave energy, comprising:
- an anchoring apparatus (A₁, A₂) for mechanically securing the installation,
- an apparatus according to one of the preceding Claims 1 to 7, and
- a float (6) for moving the actuator (3) by means of wave energy.

9. Method for operating an apparatus according to one of Claims 1 to 7,
- an electrical voltage being applied to the electrodes in response to a first predefined distance between electrical electrodes (11a, 11b) of the first generator (1) being reached,
- electrical energy being removed from the first generator (1) in response to a second predefined distance between the electrical electrodes (11a, 11b) of the first generator (1) being reached, and
- at least some of the removed energy being used to apply an electrical voltage to electrodes (12a, 12b) of the second generator (2).

10. Method according to Claim 9, the first predefined distance being a minimum distance between the electrical electrodes (11a, 11b) of the first generator (1), and/or the second predefined distance being a maximum distance between the electrical electrodes (11a, 11b) of the first generator (1).

## Revendications

1. Dispositif destiné à convertir de l'énergie mécanique en énergie électrique, comprenant :
- un premier générateur (1) comportant des électrodes électriques (11a, 11b) et un polymère électroactif (81),
- un deuxième générateur (2) comportant des électrodes électriques (12a, 12b) et un polymère électroactif (82),
- un actionneur (3) destiné à appliquer de l'énergie mécanique au premier générateur (1) et au deuxième générateur (2),
- une électronique de puissance (4) destinée à appliquer aux électrodes (11a, 11b ; 12a, 12b) une tension électrique (U_{L1}, U_{L2}),
dans lequel le polymère électroactif (81) du premier générateur (1) est conçu pour être soumis à une force de pression en réponse à un déplacement de l'actionneur (3) et le polymère électroactif (82) du deuxième générateur (82) est conçu pour être soumis à une force de traction en réponse au déplacement,
**caractérisé en ce que** l'électronique de puissance (4) comprend une capacité de circuit intermédiaire (Cᵥ), dans lequel la capacité de circuit intermédiaire (Cᵥ) stocke l'énergie absorbée au moyen du deuxième générateur (2) et fournit au moins une partie de l'énergie absorbée pour le chargement du premier générateur (1).

2. Dispositif selon la revendication 1, dans lequel le premier générateur (1) et le deuxième générateur (2) sont disposés l'un par rapport à l'autre de manière à ce que la force de pression et la force de traction s'étendent sensiblement le long d'un axe commun.

3. Dispositif selon la revendication 1 ou 2, dans lequel
- les électrodes électriques (11a, 11b ; 12a, 12b) et les polymères électroactifs (81, 82) sont disposés sensiblement le long d'un axe commun, et
- l'actionneur (3) est conçu pour introduire l'énergie mécanique entre le polymère électroactif (81) du premier générateur (1) et le polymère électroactif (82) du deuxième générateur (2).

4. Dispositif selon l'une quelconque des revendications précédentes, dans lequel les premier et deuxième générateurs (2) sont conçus, en réponse à un déplacement de l'actionneur (3), pour augmenter l'espacement entre les électrodes électriques (11a, 11b) du premier générateur (1) et pour simultanément réduire l'espacement entre les électrodes (12a, 12b) du deuxième générateur (2), et/ou dans lequel le premier générateur (1) et le deuxième générateur (2) comprennent des électrodes déformables (11a, 11b ; 12a, 12b), dans lequel le premier générateur (1) et le deuxième générateur (2) sont conçus, en réponse à un déplacement de l'actionneur (3), pour augmenter une surface d'une électrode (11a, 11b) du premier générateur (1) et pour ainsi réduire la surface d'une électrode (12a, 12b) du deuxième générateur (2).

5. Dispositif selon l'une quelconque des revendications précédentes, dans lequel la capacité de circuit intermédiaire (Cᵥ)
- est conçue pour absorber, au moyen d'un premier commutateur (S_{w1}), au moins une partie de l'énergie du premier générateur (1) et est en outre conçue pour transmettre, au moyen d'un troisième commutateur (S_{w3}), au moins une partie de l'énergie absorbée du premier générateur (1) sous la forme d'une tension électrique aux électrodes (12a, 12b) du deuxième générateur (2), et
- est conçue pour absorber, au moyen du troisième commutateur (S_{w3}), au moins une partie de l'énergie du deuxième générateur (2) et est en outre conçue pour transmettre, au moyen du premier commutateur (S_{w1}), au moins une partie de l'énergie absorbée du premier générateur (2) sous la forme d'une tension électrique aux électrodes (11a, 11b) du premier générateur (2).

6. Dispositif selon l'une quelconque des revendications précédentes, dans lequel l'électronique de puissance (4) comprend un convertisseur (5) ayant une première inductance (L_{w1}) et une deuxième inductance (L_{w2}) , dans lequel la première inductance (L_{w1}) est connectée en série au premier générateur (1) et la deuxième inductance (L_{w2}) est connectée en série au deuxième générateur (2).

7. Dispositif selon l'une quelconque des revendications précédentes, dans lequel le polymère électroactif (81, 82) des générateurs (1, 2) est soumis à l'état de repos à une pré-tension approximativement égale à la moitié de la charge mécanique moyenne à attendre en fonctionnement ou à la charge mécanique maximale à attendre en fonctionnement.

8. Installation destinée à obtenir de l'énergie électrique à partir de l'énergie des vagues, comprenant :
- un dispositif d'ancrage (A₁, A₂) destiné à fixer mécaniquement l'installation,
- un dispositif selon l'une quelconque des revendications 1 à 7, et
- un corps flottant (6) destiné à déplacer l'actionneur (3) au moyen de l'énergie des vagues.

9. Procédé de mise en fonctionnement selon l'une quelconque des revendications 1 à 7, dans lequel :
- en réponse au fait qu'un premier espacement prédéfini entre des électrodes électriques (11a, 11b) du premier générateur (1) a été atteint, une tension électrique est appliquée aux électrodes,
- en réponse au fait qu'un deuxième espacement prédéfini entre les électrodes électriques (11a, 11b) du premier générateur (1) a été atteint, de l'énergie électrique est prélevée sur le premier générateur (1), et
- au moins une partie de l'énergie prélevée est utilisée pour appliquer une tension électrique à des électrodes (12a, 12b) du deuxième générateur (2).

10. Procédé selon la revendication 9, dans lequel le premier espacement prédéfini est une distance minimale entre les électrodes électriques (11a, 11b) du premier générateur (1) et/ou le deuxième espacement prédéfini est un espacement maximal entre les électrodes électriques (11a, 11b) du premier générateur (1).
